# FASCICULE DE BREVET EUROPEEN

(11) **EP 1 010 247 B1**
(45) Date de publication et mention de la délivrance du brevet: **10.04.2002**
(21) Numéro de dépôt: 98942840.4
(22) Date de dépôt: 17.09.1998
(51) Int. Cl.: H03J 1/00

(54) **TELECOMMANDE ADAPTABLE POUR APPAREILS ELECTRIQUES DISPOSANT DE PLUSIEURS FONCTIONS A COMMANDER**
ANPASSBARE FERNBEDIENUNG FÜR ELEKTRISCHE GERÄTE MIT MEHREREN ZU STEUERENDEN FUNKTIONEN
ADAPTABLE REMOTE CONTROL FOR ELECTRICAL APPLICANCES WITH SEVERAL CONTROL FUNCTIONS

(30) Priorité: 19.09.1997 FR 9711904
(43) Date de publication de la demande: 21.06.2000
(73) Titulaire: Moransais, Charles, 1700 Fribourg (CH)
(72) Inventeur: Moransais, Charles, 1700 Fribourg (CH)
(74) Mandataire: Maureau, Philippe
(86) Numéro de dépôt international: FR9802000
(87) Numéro de publication internationale: WO9916171

(56) Documents cités:
- EP-A- 0 577 267
- US-A- 5 654 714
- PATENT ABSTRACTS OF JAPAN vol. 017, no. 337 (E-1388), 25 juin 1993 & JP 05 041891 A (NEC IC MICROCOMPUT SYST LTD), 19 février 1993
- PATENT ABSTRACTS OF JAPAN vol. 095, no. 002, 31 mars 1995 & JP 06 311567 A (CASIO COMPUT CO LTD), 4 novembre 1994

## Description

La présente invention a pour objet une télécommande adaptable pour appareils électriques disposant de plusieurs fonctions à commander.

De nombreux appareils électriques sont commandés par des télécommandes, tels que des téléviseurs, magnétoscopes ou chaînes haute-fidélité.

Un appareil est livré avec une télécommande. Toutefois, il n'est pas rare que l'utilisateur, par suite de négligence ou de façon accidentelle, détériore sa télécommande, ce qui nécessite un remplacement de celle-ci.

Une première solution consiste à se procurer une télécommande auprès du fabricant de l'appareil concerné. Toutefois, de telles télécommandes de rechange ne sont pas toujours disponibles en stock, et sont, pour l'utilisateur, d'un prix de revient élevé.

En effet, les télécommandes, utilisant une transmission infrarouge pour modifier telle ou telle fonction, disposent d'un codage qui est propre à chaque appareil, à l'intérieur d'une même marque. Une télécommande est donc spécifique à un appareil déterminé.

Il est connu, notamment par les documents US-A-5 654 714 et EP-A-O 577 267, de réaliser une télécommande adaptable qui contient les codes de commande d'un certain nombre d'appareils. L'accès à chaque code de commande est réalisé par composition sur le clavier du boîtier de télécommande d'un code numérique ou alphanumérique spécifique d'au moins quatre caractères. Il convient donc, pour sélectionner le code de commande d'un appareil, de disposer d'une notice volumineuse identifiant les codes d'accès aux différents codes de commande. Outre la difficulté de recherche et de sélection des codes, la perte de la notice rend difficile la réalisation d'une configuration ultérieure de la télécommande.

Le but de l'invention est de fournir une telle télécommande, qui puisse être configurée très rapidement et très simplement par l'utilisateur lui-même, sans nécessiter l'étude préalable d'une notice d'instructions très complexes.

A cet effet, la télécommande qu'elle concerne, comprend un micro-processeur possédant une première zone mémoire contenant un fichier des marques des principaux appareils sur le marché, et une zone mémoire contenant les fichiers des codes correspondant aux différents appareils appartenant aux différentes marques mémorisées dans le premier fichier, des moyens étant prévus pour permettre tout d'abord la sélection de la marque de l'appareil à commander, puis la sélection, à l'intérieur des fichiers de codes des appareils de cette marque, du fichier contenant les codes de commande de l'appareil considéré.

La configuration de la télécommande pour l'adapter à un appareil déterminé se fait tout d'abord en sélectionnant la marque de l'appareil, puis en sélectionnant à l'intérieur de la marque, le code de commande correspondant à l'appareil considéré.

Suivant une caractéristique de cette télécommande, la sélection de la marque de l'appareil est obtenue par appui sur une touche prédéterminée et simultanément sur une ou plusieurs autres touches successivement, telles que les touches de numérotation des programmes, qui correspondent chacune à l'identification d'une marque.

L'emballage de la télécommande, ou le boîtier lui-même de la télécommande, peut comporter une liste des marques des appareils pouvant être commandés, avec indication en regard de chaque marque, de la touche à actionner pour avoir accès au fichier du micro-processeur correspondant aux appareils de cette marque. L'opération à effectuer est simple, puisque le code de sélection d'une marque ne comporte pas plus de deux caractères.

Suivant une autre caractéristique de l'invention, la sélection des codes correspondant au type de l'appareil, est obtenue, après sélection de la marque, par appui sur une seconde touche prédéterminée et simultanément sur une ou plusieurs autres touches successivement, telles que les touches de numérotation des programmes, jusqu'à obtention de la sélection des codes de l'appareil considéré.

L'utilisateur appuie tout d'abord sur la seconde touche prédéterminée, et successivement sur une ou plusieurs autres touches, jusqu'à obtention du fonctionnement de l'appareil.

Avantageusement, après sélection d'une marque dans le fichier de la mémoire contenant les marques des principaux appareils du marché, le micro-processeur sélectionne automatiquement dans le fichier des codes de commande, le code le plus fréquent pour les appareils de la marque considérée.

Ainsi, dans de nombreux cas, la sélection de la seule marque de l'appareil permet d'aboutir directement au code de commande de l'appareil. Si l'appareil n'est pas commandé avec le code de commande le plus fréquent, qui a été sélectionné automatiquement, l'utilisateur opère de la façon indiquée précédemment en appuyant sur une touche de fonction et successivement sur différentes autres touches, telles que les touches de numérotation des programmes.

Après que ces opérations aient été effectuées successivement, la télécommande se trouve configurée pour la commande de cet appareil, et l'utilisateur peut utiliser la télécommande en appuyant de façon traditionnelle sur les différentes touches de fonction de celle-ci.

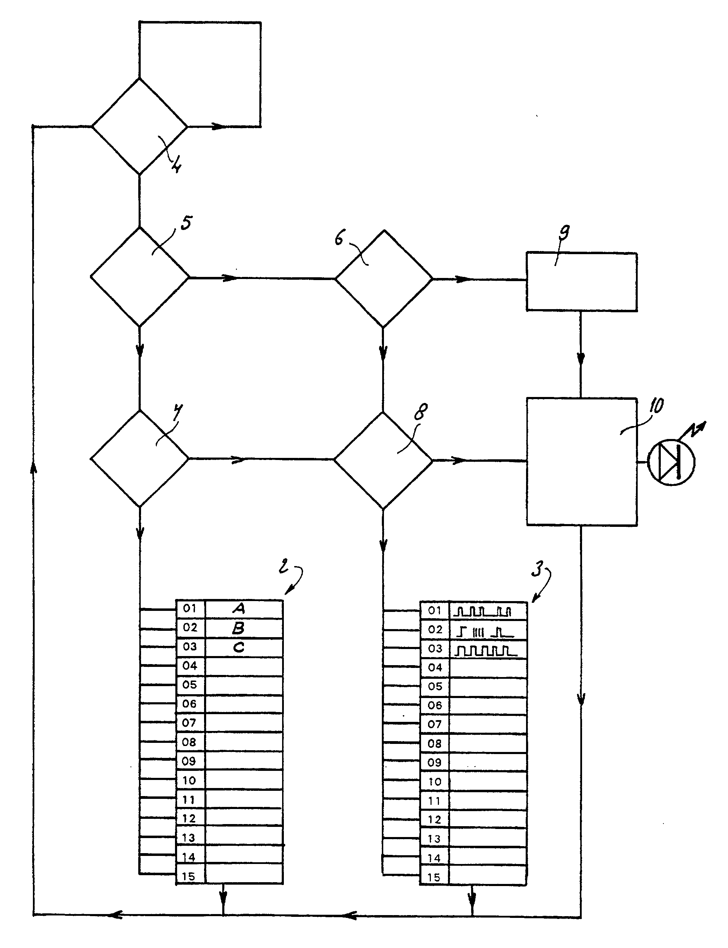

De toute façon, l'invention sera bien comprise à l'aide de la description qui suit, en référence au dessin schématique annexé, dont la figure unique est un schéma bloc permettant d'illustrer la mise en service de la télécommande en vue de sa configuration.

La figure unique du dessin annexé représente un premier fichier 2 contenu dans la mémoire d'un micro-processeur que comporte la télécommande, ce premier fichier contenant les différentes marques A, B, C... des appareils dont les codes ont été mémorisés dans la télécommande. A titre d'exemple, il est prévu quinze zones correspondant à quinze marques d'appareils.

Le schéma bloc montre également un fichier 3 qui correspond aux codes de transmission des différents appareils appartenant à une même marque. A titre d'exemple, dans le schéma bloc représenté, il existe quinze zones correspondant à quinze séries de codes différents, c'est-à-dire à quinze appareils appartenant à une même marque.

Il existe autant de fichiers de codes de transmission qu'il existe de marques d'appareils mémorisés dans le fichier 2.

Ce diagramme montre également un certain nombre d'autres fonctions gérées par le micro-processeur, à savoir un module de détection d'actionnement de n'importe quelle touche de la télécommande 4, un module 5 de détection d'actionnement de la touche d'augmentation de volume, un module 6 de détection de la diminution du volume ainsi que des modules de comparaison 7 et 8 associés aux modules 5 et 6. Ce schéma bloc illustre également un module 9 de commande des différentes fonctions d'un appareil, ainsi qu'un module d'émission 10 d'un train d'impulsions infrarouge pour la commande de l'appareil.

La configuration de la télécommande pour un appareil de marque C est la suivante.

Le micro-processeur teste tout d'abord si certaines touches sont activées ou non. Si aucune touche n'est activée, il est possible à l'utilisateur d'appuyer sur la touche de fonction de l'augmentation du volume, ce qui est détecté par le module 5, contrôlé par le module 7, et permet d'actionner une touche numérique appartenant à la télécommande, en l'occurrence la touche 03 qui correspond aux appareils de marque C. L'information sur la touche à actionner est fournie par un document imprimé, livré avec la télécommande, ou fixé au dos de la télécommande. Le micro-processeur ayant mémorisé la marque de l'appareil dont il s'agit, il convient de retenir le code de transmission correspondant à l'appareil considéré dans cette marque.

Suivant une possibilité, dès sélection dans le fichier 2 des marques, de la marque de l'appareil, le micro-processeur sélectionne automatiquement dans le fichier 3 des codes de commande le code de commande 01, qui est le code le plus fréquent pour les appareils de la marque considérée. Si l'appareil ne peut être commandé à l'aide de ce code, l'utilisateur appuie alors sur une touche de fonction, telle que la touche de diminution du volume sonore et simultanément sur une touche de numérotation des programmes pour sélectionner un autre code de commande. Si aucune commande n'est obtenue, l'utilisateur, continuant d'exercer une pression sur la touche de fonction, exerce successivement une action sur les touches de numérotation des programmes, jusqu'à ce que la télécommande soit active. Dès que la télécommande est active, l'utilisateur relâche la pression exercée sur la touche de diminution de volume et sur la dernière touche de numérotation des programmes concernés, le code de transmission correspondant à l'appareil à commander étant alors sélectionné par le micro-processeur et demeurant actif dans la mémoire de celui-ci. La télécommande étant configurée aux caractéristiques de l'appareil à commander, l'utilisateur peut agir sur les différentes fonctions à initier ou à modifier, cette commande étant reçue par le module 9 qui le transmet au module d'émission 10.

Comme il ressort de ce qui précède, l'invention apporte une grande amélioration à la technique existante en fournissant une télécommande adaptable, de structure simple, ne nécessitant pas de la part de l'utilisateur de manipulations compliquées pour l'adapter au type de l'appareil à commander.

Comme il va de soi, l'invention ne se limite pas à la seule forme d'exécution de cette télécommande, décrite ci-dessus à titre d'exemple, elle en embrasse au contraire toutes les variantes. C'est ainsi notamment que le micro-processeur pourrait ne pas sélectionner automatiquement le code de commande le plus fréquent, l'utilisateur effectuant uniquement de façon manuelle la sélection du code de commande dans le fichier 3 ou encore que les touches de fonction pourraient être constituées non pas par les touches de réglage du volume sonore mais par d'autres touches, y compris des touches spécifiques, sans que l'on sorte pour autant du cadre de l'invention.

## Revendications

1. Télécommande adaptable pour appareils électriques disposant de plusieurs fonctions à commander, **caractérisée en ce qu'**elle comprend un micro-processeur possédant une première zone mémoire contenant un fichier (2) des marques des principaux appareils sur le marché, et une zone mémoire contenant les fichiers (3) des codes correspondant aux différents appareils appartenant aux différentes marques mémorisées dans le premier fichier, des moyens étant prévus pour permettre tout d'abord la sélection de la marque de l'appareil à commander, puis la sélection, à l'intérieur des fichiers (3) de codes des appareils de cette marque, du fichier contenant les codes de commande de l'appareil considéré.

2. Télécommande adaptable selon la revendication 1, **caractérisée en ce que** la sélection de la marque de l'appareil est obtenue par appui sur une touche prédéterminée et simultanément sur une ou plusieurs autres touches, telles que les touches de numérotation des programmes (1, 2, 3...), qui correspondent chacune à l'identification d'une marque.

3. Télécommande adaptable selon la revendication 2, **caractérisée en ce que** la sélection des codes correspondant au type de l'appareil, est obtenue, après sélection de la marque, par appui sur une seconde touche prédéterminée et simultanément sur une ou plusieurs autres touches successivement, telles que les touches de numérotation des programmes (1, 2, 3...), jusqu'à obtention de la sélection des codes de l'appareil considéré.

4. Télécommande adaptable selon la revendication 2, **caractérisée en ce qu'**après sélection d'une marque dans le fichier de la mémoire contenant les marques des principaux appareils du marché, le micro-processeur sélectionne automatiquement dans le fichier des codes de commande, le code le plus fréquent pour les appareils de la marque considérée.

## Patentansprüche

1. Anpassbare Fernbedienung für elektrische Geräte mit mehreren zu steuernden Funktionen, **dadurch gekennzeichnet, dass** sie einen Mikroprozessor aufweist mit einem ersten Speicherbereich, der eine Datei (2) der auf dem Markt hauptsächlichen Marken enthält, und einem zweiten Speicherbereich, der die Dateien (3) der Codes enthält, die den verschiedenen Geräten entsprechen und den in der ersten Datei gespeicherten verschiedenen Marken angehören, wobei Mittel vorgesehen sind, um zunächst die Auswahl der Marke des zu steuernden Geräts und anschließend innerhalb der Dateien (3) der Codes der Geräte dieser Marke die Auswahl der Datei zu ermöglichen, welche die Steuerungscodes des betreffenden Geräts enthält.

2. Anpassbare Fernbedienung nach Anspruch 1, **dadurch gekennzeichnet, dass** die Auswahl der Marke des Geräts erzielt wird durch Drücken auf eine vorbestimmte Taste und gleichzeitig auf eine oder mehrere andere Tasten, wie z.B. die Nummerntasten der Programme (1, 2, 3, ...), die jeweils der Identifikation einer Marke entsprechen.

3. Anpassbare Fernsteuerung nach Anspruch 2, **dadurch gekennzeichnet, dass** die Auswahl der dem Gerätetyp entsprechenden Codes nach der Auswahl der Marke erzielt wird durch Drücken einer zweiten vorbestimmten Taste und gleichzeitiges sukzessives Drücken einer oder mehrerer anderer Tasten, wie z.B. die Nummerntasten der Programme (1, 2, 3, ...), die jeweils der Identifikation einer Marke entsprechen.

4. Anpassbare Fernsteuerung nach Anspruch 2, **dadurch gekennzeichnet, dass** nach der Auswahl einer Marke aus der Datei des Speichers, der die Marken der hauptsächlichen Geräte des Marktes enthält, der Mikroprozessor auf der Datei der Steuerungscodes automatisch den häufigsten Code für die Geräte der betreffenden Marke auswählt.

## Claims

1. Adaptable remote control for items of electrical equipment having a plurality of functions to be controlled, **characterised In that** it comprises a microprocessor having a first memory zone containing a file (2) of the makes of the principal items of equipment on the market, and a memory zone containing files (3) of the codes corresponding to the different items of equipment belonging to the different makes stored in the first file, means being provided to allow firstly the make of the item of equipment to be controlled to be selected, and then the file containing the control codes for the item of equipment concerned to be selected from within the files (3) of codes for items of equipment of this make.

2. Adaptable remote control according to claim 1, **characterised in that** the make of the item of equipment is selected by pressing a predetermined key and, at the same time, one or more other keys, such as the programme numbering keys (1, 2, 3, etc), each of which corresponds to the identifying of a make.

3. Adaptable remote control according to claim 2, **characterised in that**, the make having been selected, the codes corresponding to the type of equipment are selected by pressing a second predetermined key and, at the same time, one or more other keys in succession, such as the programme numbering keys (1, 2, 3, etc) until the codes for the item of equipment concerned are selected.

4. Adaptable remote control according to claim 2, characterlsed in that, a make having been selected in the file In the memory which contains the makes of the principal items of equipment on the market, the microprocessor automatically selects from the file of control codes the code which is commonest for items of equipment of the make concerned.
